# EUROPÄISCHE PATENTSCHRIFT

(11) **EP 2 686 562 B1**
(45) Veröffentlichungstag und Bekanntmachung des Hinweises auf die Patenterteilung: **03.01.2018**
(21) Anmeldenummer: 11708411.1
(22) Anmeldetag: 14.03.2011
(51) Int. Cl.: F15B 13/08

(54) **MODULANORDNUNG**
MODULE ARRANGEMENT
AGENCEMENT DE MODULES

(43) Veröffentlichungstag der Anmeldung: 22.01.2014
(73) Patentinhaber: Festo AG & Co. KG, 73734 Esslingen (DE)
(72) Erfinder: BERNER, Michael, 73230 Kirchheim (DE); FORCHT, Ralf, 73240 Wendlingen (DE)
(74) Vertreter: Patentanwälte Magenbauer & Kollegen Partnerschaft mbB
(86) Internationale Anmeldenummer: PCT/EP2011/001241
(87) Internationale Veröffentlichungsnummer: WO 2012/122996

(56) Entgegenhaltungen:
- EP-A1- 0 952 359
- WO-A1-2007/042090
- CH-A5- 683 021
- DE-A1- 10 316 129

## Beschreibung

Die Erfindung betrifft eine Modulanordnung mit mehreren in einer Stapelrichtung aneinandergereihten Funktionsmodulen, die untereinander fluidisch und elektrisch kommunizierend verbunden sind, wobei jeweils wenigstens ein Funktionsmodul als Steuermodul zur Bereitstellung und/oder Verarbeitung von Signalen daran aufgereihter Funktionsmodule und wenigstens ein Funktionsmodul als Ventilmodul zur Beeinflussung wenigstens einer Fluidströmung und wenigstens ein Funktionsmodul als Signalverarbeitungsmodul zur Verarbeitung und/oder Ausgabe elektrischer Signale von und/oder an Externkomponenten ausgebildet ist und jeweils einen plattenförmigen Grundkörper umfasst, der zwei zueinander parallele, einander entgegengesetzte Fügeflächen aufweist, deren Flächennormalen die Stapelrichtung bestimmen und zur Anlage an Fügeflächen benachbarter Grundkörper ausgebildet sind, wobei der Grundkörper Anschlussmittel umfasst, die für eine Weiterleitung von elektrischen Signalen und/oder elektrischen Versorgungsspannungen und/oder Fluidströmungen zwischen benachbarten Funktionsmodulen längs der Stapelrichtung ausgebildet sind und wobei sich mehrere vom Steuermodul ansteuerbare Signalleitungen zur Übertragung von Steuersignalen, die zur direkten Ansteuerung einzelner Funktionsmodule vorgesehen sind, längs der Stapelrichtung der Funktionsmodule erstrecken.

Aus der EP 0952359 A1 ist ein modulares elektrofluidisches Baukastensystem mit auf einer Schiene anbringbaren und aneinander anreihbaren Modulen bekannt. Dabei weisen fluidische Module Sammelkanäle für Aktoranschlüsse auf, während elektrische Module mit Busanschlüssen und elektrischen Anschlüssen für Aktoren versehen sind. Zudem ist wenigstens ein Schnittstellenmodul vorgesehen, das auf einer Anschlussseite eine erste Anschlusskonfiguration mit elektrischen und fluidischen Anschlüssen sowie einer Kontur aufweist, die an die Module des Baukastensystems angepasst sind, und auf der gegenüberliegenden Anschlussseite eine von der ersten verschiedene, zweite Anschlusskonfiguration mit elektrischen Anschlüssen sowie einer Kontur aufweist, die an auf derselben Schiene befestigte Module eines fremden Modulsystems angepasst sind.

Die CH 683 021 A5 offenbart eine Anordnung mit mehreren Magnetventilen, die elektrische Zuleitungen zur Ansteuerung einer Ansteuereinheit über ein Bus-Modul mit einer Stromversorgungsleitung zu einer Spannungsquelle und einer Bus-SignalLeitung an eine Steuerung aufweist. An jedes Ventil ist ein Decoder-Modul angeschlossen und diese Decoder-Module sind mittels einer lokalen Bus- und Stromversorgungsleitung an die Steuerung oder an das Bus-Modul anschließbar.

Aus der WO 2007042090 A1 ist ein Modulsystem aus Seite an Seite anreihbaren Einzelmodulen bekannt, das ein Kopfmodul mit mindestens einem Anschluss für ein externes Bussignal auf einem externen Bus, mindestens einem pneumatischen Versorgungsanschluss, einem elektrischen Versorgungsanschluss und, jeweils an derselben Seite herausgeführt: eine serielle Busschnittstelle für einen internen seriellen Bus, eine elektrische Versorgungs-Schnittstelle, eine Multipol-Schnittstelle und eine pneumatische Versorgungs-Schnittstelle umfasst. Weiterhin ist mindestens ein Funktionsmodul mit, jeweils von einer Seite zur gegenüberliegenden Seite durchführend und an je eine entsprechende Schnittstelle des Kopfmoduls angeschlossen: einer internen seriellen Busleitung, elektrischen Versorgungsleitungen, elektrischen Multipol-Leitungen und einer pneumatischen Versorgungsleitung vorgesehen; wobei das Kopfmodul serielle Bussignal in Multipol-Signale umsetzt und diese an der Multipol-Schnittstelle ausgibt; das Funktionsmodul selektiv wenigstens eine der Multipol-Leitungen abzweigt und mit einem darauf geführten Signal eine pneumatische oder elektrische oder sowohl eine pneumatische als auch eine elektrische Funktion ausführt.

Aus der DE 103 16 129 A1 ist ein Diagnosemodul zur Anreihung an mindestens ein Ventilmodul einer fluidtechnischen Ventilbatterie bekannt. Dabei weist die Ventilbatterie in einer Reihenrichtung angeordnete Montageplätze für Ventilmodule auf, die jeweils mindestens ein mit einem beweglichen Ventilglied ausgestattetes Ventil enthalten, wobei an den Montageplätzen Ventilbatterie-Kontaktmittel zur Herstellung von Bus-Kommunikationsverbindungen mit den Ventilmodulen vorhanden sind. Dabei ist vorgesehen, dass das Diagnosemodul an Stelle eines Ventilmoduls an einem der Montageplätze der Ventilbatterie montierbar ist und das es mit den Ventilbatterie-Kontaktmitteln kommunizierende Modul-Kontaktmittel aufweist, die zu einer Identifizierung des Diagnosemoduls über die Bus-Kommunikationsverbindungen ausgestaltet sind.

Somit besteht die Aufgabe der Erfindung darin, eine Modulanordnung bereitzustellen, bei der eine verbesserte Variabilität hinsichtlich der Anordnung und Ausbildung der einzelnen Funktionsmodule erreichbar ist.

Diese Aufgabe wird gemäß einem ersten Aspekt der Erfindung für eine Modulanordnung der eingangs genannten Art mit den Merkmalen des Anspruch 1 gelöst. Hierbei ist vorgesehen, dass in wenigstens eine Signalleitung zwischen das Signalverarbeitungsmodul und das Steuermodul wenigstens eine Speichereinrichtung zur Erfassung, Zwischenspeicherung und Weiterleitung wenigstens eines elektrischen Signals einer Externkomponente elektrisch eingeschleift ist.

Mit Hilfe der Speichereinrichtung, die je nach technischer Ausführungsform auch als Latch bezeichnet werden kann, ist es möglich, elektrische Signale einer Externkomponente, bei der es sich beispielsweise um einen Sensor handeln kann, zu erfassen und zwischenzuspeichern und zu einem gegebenen Zeitpunkt, der nicht zwingend mit dem Zeitpunkt der Erfassung des Messwerts durch die Externkomponente übereinstimmen muss, über die Signalleitung an das Steuermodul weiterzuleiten.

Hierdurch wird die Möglichkeit geschaffen, das wenigstens eine elektrische Signal der Externkomponente über die Signalleitungen zu übertragen, deren Hauptaufgabe zunächst darin besteht, vom Steuermodul bereitgestellte Steuersignale zur direkten Ansteuerung an einzelne Funktionsmodule zu übertragen. Da eine gleichzeitige Übertragung von Steuersignalen einerseits und elektrischen Signalen von Externkomponenten andererseits erhebliche Schwierigkeiten bereitet, ist es somit vorteilhaft, unter Ausnutzung der Zwischenspeicherung durch die Speichereinrichtung denjenigen Zeitpunkt abzuwarten, zu dem eine Übertragung des elektrischen Signals der Externkomponente in Richtung des Steuermoduls ohne störende Beeinflussung durch Steuersignale, die insbesondere in entgegengesetzter Richtung über die Signalleitung übertragen werden müssen, vorgenommen werden kann. Durch diese Doppelnutzung der Signalleitung ist ein kostengünstiger Aufbau der Funktionsmodule und der daran vorgesehenen Anschlussmittel möglich, da die zwischen den Funktionsmodulen auszutauschenden Signale, insbesondere Steuersignale und elektrische Signale von Externkomponenten, in unterschiedlichen Richtungen auf einer geringen Anzahl von Steuerleitungen übertragen werden können.

Bei einer weiteren Ausführungsform der Erfindung werden die Steuersignale einerseits und die elektrischen Signale von Externkomponenten andererseits jeweils auf diskreten Signalleitungen geführt, wodurch bei der Übertragung der elektrischen Signale von Externkomponenten keine Rücksicht auf gegebenenfalls zu übertragende Steuersignale des Steuermoduls genommen werden muss. Bei dieser Ausführungsform der Erfindung dient die Speichereinrichtung beispielsweise zur elektronischen Stabilisierung der elektrischen Signale der Externkomponenten, wenn diese beispielsweise zeitlichen Schwankungen unterworfen sind, die insbesondere bei einer digitalen Weiterleitung der elektrischen Signale zu einer stetigen Umschaltung zwischen dem High-Pegel und dem Low-Pegel führen würde.

Vorteilhafte Weiterbildungen der Erfindung sind Gegenstand der Unteransprüche.

Zweckmäßig ist es, wenn die Funktionsmodule jeweils als Baugruppe aus dem Grundkörper und einer daran angeordneten, als elektronische Steuereinheit und/oder fluidischen Steuereinheit und/oder Signalverarbeitungseinheit modular ausgebildeten Funktionseinheit aufgebaut sind. Die modular ausgebildete Funktionseinheit bildet zusammen mit dem Grundkörper das jeweilige Funktionsmodul und ist zu diesem Zweck mit dem Grundkörper verriegelbar. Bei der Verriegelung der jeweiligen Funktionseinheit am entsprechenden Grundkörper werden vorzugsweise auch elektrische und/oder fluidische Verbindungen zwischen der Funktionseinheit und dem Grundkörper hergestellt. Eine elektronische Steuereinheit kann beispielsweise dazu eingesetzt werden, Signale aus einem übergeordneten Datenübertragungssystem, beispielsweise einem Bussystem, zu verarbeiten und an die anderen Funktionsmodule der Modulanordnung weiterzugeben. Ferner kann die elektronische Steuereinheit Signale aus der Modulanordnung, die beispielsweise von den Funktionsmodulen oder daran angeschlossenen Externkomponenten bereitgestellt werden, an das übergeordnete Datenübertragungssystem, insbesondere gemäß einem vorgebbaren Datenprotokoll, bereitstellen. Eine fluidische Steuereinheit kann beispielsweise ein oder mehrere, insbesondere elektrisch ansteuerbare, Ventile umfassen, die beispielsweise zur Beeinflussung von fluidischen Zweigströmungen aus einer längs der Stapelrichtung strömenden Fluidströmung vorgesehen sind. Bei den Ventilen kann es sich beispielsweise um elektrisch ansteuerbare Magnetventile oder Piezoventile handeln. Eine Signalverarbeitungseinheit kann insbesondere zur Weiterleitung von Signalen an Externkomponenten, beispielsweise elektrische Aktoren, und/oder zur Verarbeitung und Übertragung von Signalen, die von Externkomponenten wie Sensoren stammen, an ein Steuermodul ausgebildet sein. Die Funktionsmodule können über die längs der Stapelrichtung vorgesehenen Signalleitungen in unidirektionaler oder bidirektionaler Datenübertragung mit benachbarten oder beabstandet angeordneten Funktionsmodulen, insbesondere mit Steuermodulen, kommunizieren.

Bei einer Weiterbildung der Erfindung ist vorgesehen, dass wenigstens eine Signalleitung an einem ersten Endbereich mit einem Funktionsmodul verbunden ist und an einem zweiten Endbereich eine, insbesondere im Steuermodul ausgebildete, elektrische Verzweigung aufweist, wobei ein erster Zweig der Signalleitung mit einer im Steuermodul angeordneten Sendeeinrichtung und ein zweiter Zweig der Signalleitung mit einer im Steuermodul angeordneten Empfangseinrichtung elektrisch verbunden ist. Durch eine derartige elektrische Verzweigung der Signalleitung im Steuermodul kann einerseits eine vom Steuermodul ausgehende Beaufschlagung der Signalleitung mit einem Steuersignal, beispielsweise mit elektrischer Leistung zur Ansteuerung eines Magnetventils, erfolgen. Andererseits ist dadurch eine Übertragung eines elektrischen Signals einer Externkomponente, beispielsweise eines Sensors, die mit einem beispielsweise als Signalverarbeitungseinheit ausgebildeten Funktionsmodul verbunden ist, an das Steuermodul möglich. Somit wird die jeweilige Signalleitung, die längs der Stapelrichtung durch wenigstens ein Funktionsmodul verläuft, in doppelter Weise genutzt. Da die Sendeeinrichtung und die Empfangseinrichtung aufgrund der unterschiedlichen Funktionalitäten eine erheblich voneinander abweichende Bauweise aufweisen können, ist es vorteilhaft, die Signalleitung elektrisch zu verzweigen. Dadurch können die Sendeeinrichtung und die Empfangseinrichtung räumlich voneinander getrennt angeordnet werden, wodurch jeweils eine besonders vorteilhafte Aufbauweise für diese Komponenten gewährleistet werden kann. Besonders vorteilhaft ist es, wenn die elektrische Verzweigung im Steuermodul ausgebildet ist, da hierdurch die Steuerleitungen in den aneinander aufgereihten Funktionsmodulen einheitlich ausgebildet werden können und somit eine Aneinanderreihung der Funktionsmodule in beliebiger Reihenfolge ermöglicht wird.

In weiterer Ausgestaltung der Erfindung ist vorgesehen, dass die Empfangseinrichtung für eine Statusüberwachung eines vom Steuermodul an wenigstens ein Funktionsmodul über die Signalleitung übertragbaren Steuersignals ausgebildet ist. Bei einer derartigen Statusüberwachung beobachtet die Empfangseinrichtung den Strom- und/oder Spannungsverlauf auf der Signalleitung und ermöglicht hiermit eine Aussage, ob das von dem Steuermodul angesteuerte Funktionsmodul auch den gewünschten Zustand, beispielsweise ein Öffnen oder Schließen eines Ventils, eingenommen hat. Hierbei ermöglicht die elektrische Verzweigung der Signalleitung die Überwachung eines Schaltbeziehungsweise Steuerbefehls, vorzugsweise in Echtzeit.

Vorteilhaft ist es, wenn die Sendeeinrichtung und die Empfangseinrichtung über eine im Steuermodul angeordnete Verarbeitungseinrichtung miteinander gekoppelt sind, die derart ausgebildet ist, dass ein gleichzeitiges Senden von Steuersignalen über eine Signalleitung und ein Empfangen von elektrischen Signalen einer Externkomponente auf der gleichen Signalleitung verhindert wird. Hierdurch kann beispielsweise vermieden werden, dass die für den Empfang von relativ schwachen elektrischen Signalen von Externkomponenten ausgebildete Empfangseinrichtung mit einem erheblich stärkeren elektrischen Signal der Sendeeinrichtung, das beispielsweise zur Ansteuerung eines Magnetventils vorgesehen ist, zu einem Zeitpunkt beaufschlagt wird, zu dem die Empfangseinrichtung auch empfangsbereit ist. Da hierdurch möglicherweise ein fehlerhaftes Eingangssignal an der Empfangseinrichtung oder gegebenenfalls eine Funktionsstörung der Empfangseinrichtung auftreten könnte, wird mit Hilfe der Verarbeitungseinrichtung sichergestellt, dass zu denjenigen Zeitpunkten, zu denen die Sendeeinrichtung die Signalleitung mit starken elektrischen Signalen beaufschlagt, keine Empfangsbereitschaft der Empfangseinrichtung vorliegt.

Zweckmäßig ist es, wenn wenigstens eine Speichereinrichtung zur Erfassung, Zwischenspeicherung und Weiterleitung wenigstens eines elektrischen Signals einer Externkomponente im Steuermodul ausgebildet ist. Hierdurch kann von einem beliebig in der Modulanordnung angeordneten Funktionsmodul ein elektrisches Signal einer Externkomponente an das Steuermodul weitergeleitet werden, um dort mit Hilfe der Speichereinrichtung zwischengespeichert und zum gegebenen Zeitpunkt einer entsprechenden Verarbeitung zugeführt zu werden.

In weiterer Ausgestaltung der Erfindung ist vorgesehen, dass wenigstens eine Speichereinrichtung zur Erfassung, Zwischenspeicherung und Weiterleitung wenigstens eines elektrischen Signals einer Externkomponente in einem Funktionsmodul ausgebildet ist. Hierdurch wird an die entsprechend zugeordnete Signalleitung ein stabiles elektrisches Signal der Externkomponente bereitgestellt, das dadurch in einfacher Weise im Steuermodul verarbeitet werden kann. Bei einer derartigen Ausbildung der entsprechenden Funktionsmodule kann das Steuermodul einfacher gestaltet werden als wenn die Speichereinrichtung im Steuermodul vorgesehen ist.

Bevorzugt ist der Speichereinrichtung im Funktionsmodul eine Auswahleinrichtung zugeordnet, die zur Auswahl derjenigen Signalleitungen ausgebildet ist, die mit einer im Steuermodul angeordneten Empfangseinrichtung elektrisch verbunden sind, um eine Signalübertragung von der Speichereinrichtung über die ausgewählten Signalleitungen zu gewährleisten. Die Aufgabe der Auswahleinrichtung besteht darin, diejenigen Signalleitungen zu identifizieren, die mit Empfangseinrichtungen verbunden sind, um ausschließlich über diese Signalleitungen die elektrischen Signale von Externkomponenten an das Steuermodul zu übertragen. Nachdem sich die mit der Empfangseinrichtung im Steuermodul verbundenen Signalleitungen aufgrund der Modularität der Modulanordnung nicht von vornherein deterministisch bestimmen lassen, kann beispielsweise vorgesehen sein, beim Einschalten der Modulanordnung zunächst alle Sendeeinrichtungen anzusprechen und entsprechende Steuersignale über die Signalleitungen in die aneinandergereihten Module abzugeben, so dass die Auswahleinrichtung die Gelegenheit erhält, festzustellen, über welche Signalleitungen Steuersignale übertragen werden. In einem nachfolgenden Schritt können dann von der Auswahleinrichtung selbsttätig Prüfsignale über die im vorhergehenden Schritt identifizierten Steuerleitungen, die nicht mit Sendeeinrichtungen verbunden sind, gesendet werden, um anschließend durch eine geeignete Rückkopplung zwischen der Auswahleinrichtung einerseits und dem Steuermodul andererseits zu bestätigen, dass die ausgewählten Steuerleitungen tatsächlich auch für die Übertragung von elektrischen Signalen von Externkomponenten geeignet sind. vorzugsweise ist ein Funktionsmodul mit einer derartigen Auswahleinrichtung am Ende einer Modulanordnung und entfernt vom Steuermodul, das vorzugsweise am anderen Ende der Modulanordnung angeordnet ist, angeordnet. Hierdurch wird die Datenübertragung zwischen dem mit der Auswahleinrichtung ausgestatteten Funktionsmodul und dem Steuermodul erheblich erleichtert.

Zweckmäßig ist es, wenn im Grundkörper ein längs der Stapelrichtung erstreckter Aufnahmeschacht ausgebildet ist, in dem eine austauschbare, modular ausgebildete elektrische Leitungseinrichtung angeordnet ist, durch die Signalleitungen längs der Stapelrichtung durchgeschleift sind. Die Leitungseinrichtung dient in einer Doppelfunktion zum einen zur Weiterleitung von elektrischen Signalen, die über die Signalleitungen von dem jeweils vorhergehenden Funktionsmodul an das jeweils nachfolgende Funktionsmodul weitergeleitet werden soll. Zum anderen dient die Leitungseinrichtung zudem zur Bereitstellung von elektrischen Signalen an das Funktionsmodul, in dem die Leitungseinrichtung angeordnet ist. Hierbei kann vorgesehen sein, dass die Leitungseinrichtung über eine reine elektrische Kontaktierung hinaus auch eine Verarbeitung von Signalen, insbesondere mit Hilfe elektrischer Schaltungen wie Verstärkern oder digitalen Signalverarbeitungseinrichtungen, vornimmt. Vorzugsweise ist die Leitungseinrichtung derart ausgebildet, dass an einer der beiden Fügeflächen eine über die Fügefläche hinausragende Steckeinrichtung und an der anderen Fügefläche eine korrespondierende, vertieft ausgebildete Steckausnehmung umfasst. Die Leitungseinrichtung bildet eine eigenständige Baugruppe, die modular in den Grundkörper des jeweiligen Funktionsmoduls eingesteckt werden kann, so dass die Leitungseinrichtung jeweils individuell auf die Funktionalität des Funktionsmoduls angepasst werden kann, ohne hierzu Änderungen am Grundkörper vornehmen zu müssen. Beispielsweise sind in einer Modulanordnung, die aus unterschiedlichen Funktionsmodulen aufgebaut ist, auch unterschiedliche Typen von Leitungseinrichtungen vorgesehen, die auf die jeweilige Funktionalität der unterschiedlichen Funktionsmodule angepasst sind. Beispielsweise kann eine erste Leitungseinrichtung für Steuermodule vorgesehen sein, eine zweite Ausführungsform einer Leitungseinrichtung kann für Ventilmodule sowie eine dritte Ausführungsform der Leitungseinrichtung für Signalverarbeitungsmodule vorgesehen sein.

Bei einer vorteilhaften Weiterbildung der Erfindung ist vorgesehen, dass in der elektrischen Leitungseinrichtung ein Versatz der Signalleitungen quer zur Stapelrichtung um ein ganzzahliges Vielfaches einer Teilung benachbarter Signalleitungen vorgesehen ist, um eine elektrische Z-Verkettung der Signalleitungen auszubilden. Mit Hilfe einer derartigen elektrischen Z-Verkettung von Signalleitungen kann die gewünschte Modularität der Funktionsmodule mit den darin aufgenommenen elektrischen Leitungseinrichtungen in einfacher Weise realisiert werden. Sofern beispielsweise vorgesehen wird, ausgehend von einem Steuermodul insgesamt zehn Signalleitungen zur direkten Ansteuerung einzelner Funktionsmodule bereitzustellen und sofern weiterhin vorgesehen ist, dass jedes der aneinandergereihten Funktionsmodule jeweils ein Steuersignal über eine einzige Signalleitung erhält, so können über die Z-Verkettung insgesamt zehn Funktionsmodule angesteuert werden, ohne dass hierzu aufwendige Kontaktierungsmaßnahmen getroffen werden, da in jedem Funktionsmodul aufgrund des Versatzes der Steuerleitungen jeweils genau die Steuerleitung endet, die dem entsprechenden Funktionsmodul auch zugeordnet ist.

Bevorzugt ist im Grundkörper eine quer zur Stapelrichtung ausgerichtete, vom Aufnahmeschacht ausgehende Ausnehmung ausgebildet, die eine elektrische Kopplung zwischen der Leitungseinrichtung und dem jeweils zugeordneten Funktionsmodul ermöglicht. Durch die Ausnehmung im Grundkörper wird ein unmittelbares Einkoppeln des Funktionsmoduls auf die Leitungseinrichtung ermöglicht, ohne dass hierfür eine Zwischenkontaktierung notwendig wäre, die beispielsweise im Grundkörper zu integrieren wäre, so dass hierdurch die Kontaktsicherheit zwischen Funktionsmodul einerseits und Leitungseinrichtung andererseits erhöht wird.

Die der Erfindung zugrundeliegende Aufgabe wird gemäß einem zweiten Aspekt der Erfindung dadurch gelöst, dass ein serielles Bussystem zur Datenübertragung zwischen dem Steuermodul und wenigstens einem Signalverarbeitungsmodul vorgesehen ist und dass das Signalverarbeitungsmodul mit Koppelmitteln versehen ist, die zur Einkopplung von Signalen der Externkomponenten in das serielle Bussystem und/oder zur Auskopplung von Signalen an die Externkomponenten aus dem seriellen Bussystem ausgebildet sind. Hierdurch können die elektrischen Signale der Externkomponenten unmittelbar in das serielle Bussystem eingekoppelt werden oder Signale zur Übertragung an die Externkomponenten aus dem seriellen Bussystem ausgekoppelt werden. Somit kann das serielle Bussystem in einer Doppelfunktion zum einen zur seriellen Bereitstellung von Steuersignalen an Funktionskomponenten genutzt werden, wobei diese Steuersignale über das serielle Bussystem an ein geeignet ausgebildetes Funktionsmodul bereitgestellt werden müssen, um eine Wandlung aus den seriellen Bussignalen in die Bussignale für die einzelnen Funktionsmodule vorzunehmen. Darüber hinaus dient das serielle Bussystem für eine unmittelbare Datenkommunikation zwischen Externkomponenten und dem Steuermodul.

Vorteilhafte Ausführungsformen der Erfindung sind in der Zeichnung dargestellt. Hierbei zeigen:
- Figur 1: eine schematische Darstellung einer Modulanordnung, die aus mehreren aneinandergereihten Funktionsmodulen aufgebaut ist,
- Figur 2: eine perspektivische Darstellung verschiedener, miteinander kombinierbarer Komponenten eines Funktionsmoduls,
- Figur 3: einen ersten schematischen Schaltplan für die elektrische Verschaltung von Funktionsmodulen gemäß einer ersten Ausführungsform,
- Figur 4: einen Schaltplan für die elektrische Verschaltung der Funktionsmodule gemäß einer zweiten Ausführungsform und
- Figur 5: einen schematischen Schaltplan für die elektrische Verschaltung von Funktionsmodulen gemäß einer dritten Ausführungsform.

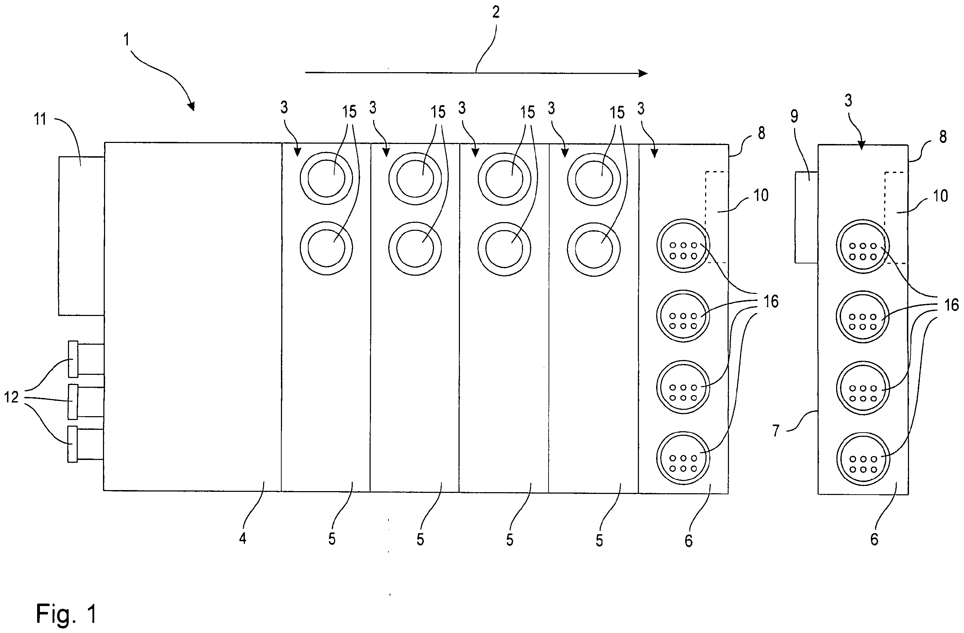

Eine in der Figur 1 dargestellte Modulanordnung 1 umfasst mehrere längs einer Stapelrichtung 2 aneinandergereihte Funktionsmodule 3. Exemplarisch sind drei unterschiedliche Typen von Funktionsmodulen 3 vorgesehen, nämlich ein Steuermodul 4, mehrere Ventilmodule 5 sowie mehrere Signalverarbeitungsmodule 6. Das Steuermodul 4 ist zur Kopplung der daran aufgereihten Ventilmodule 5 und Signalverarbeitungsmodule 6 mit einem übergeordneten, nicht dargestellten Datenübertragungssystem, beispielsweise einem Feldbus, ausgebildet. Dazu weist das Steuermodul 4, wie nachstehend näher beschrieben wird, mehrere Komponenten auf, die eine entsprechende Signalverarbeitung vornehmen können, um die vom übergeordneten Datenübertragungssystem bereitgestellten Daten an die Ventilmodule 5 und die Signalverarbeitungsmodule 6 weiterleiten zu können. Im Steuermodul 4 sind weiterhin auch Komponenten vorgesehen, um gegebenenfalls elektrische Signale von nicht dargestellten Externkomponenten, die an den Signalverarbeitungsmodulen 6 angeschlossen sind, zu verarbeiten und an die übergeordnete

Datenübertragungseinrichtung weitergeben zu können. Die Funktionsmodule 3 weisen jeweils zwei einander entgegengesetzte Fügeflächen 7, 8 auf, wie sie beispielsweise an dem Signalverarbeitungsmodul 6 angedeutet sind, das zur Montage an die bereits längs der Stapelrichtung 2 aneinandergereihten Funktionsmodule 3 bereitsteht. Die Fügeflächen 7, 8 sind zueinander geometrisch korrespondierend, exemplarisch eben ausgebildet und ermöglichen eine flächige Anlage benachbarter Funktionsmodule 3. Exemplarisch wird das abgesetzt dargestellte Signalverarbeitungsmodul 6 mit seiner ersten Fügefläche 7 in flächige Anlage mit der zweiten Fügefläche 8 gebracht, die an dem vorhergehenden Signalverarbeitungsmodul 6 ausgebildet ist. Für eine elektrische Kopplung zwischen den Funktionsmodulen weisen diese jeweils an der ersten Fügefläche 7 einen Stecker 9 auf, der in eine nicht sichtbare, an der zweiten Fügefläche 8 ausgebildete und gestrichelt angedeutete Buchse 10 einsteckbar ist, um nachstehend näher beschriebene Signalleitungen der jeweiligen Funktionsmodule 3 miteinander zu verbinden.

Am Steuermodul 4 ist ein Busanschluss 11 ausgebildet, der zur Aufnahme eines nicht dargestellten Bussteckers dient, wobei über diesen Busstecker elektrische Signale des übergeordneten Datenübertragungssystems an das Steuermodul 4 bereitgestellt werden können und Ausgangssignale des Steuermoduls 4 an das übergeordnete Datenverarbeitungssystem übertragen werden können. Des Weiteren sind am Steuermodul mehrere Fluidversorgungsanschlüsse 12 vorgesehen, die für eine Kopplung des Steuermoduls 4 mit wenigstens einer nicht dargestellten Fluidquelle, beispielsweise einer Druckluftquelle, vorgesehen sind. Exemplarisch ist vorgesehen, dass sämtliche Funktionsmodule 3 mit Hilfe der Fluidversorgungsanschlüsse 12 zentral und längs der Stapelrichtung 2 von wenigstens einem Fluid durchflutet werden.

An den Ventilmodulen 5, die nachstehend noch näher beschrieben werden, sind jeweils Fluidausgänge 15 vorgesehen, an die beispielsweise jeweils ein Druckluftschlauch angeschlossen werden kann, um einen nicht dargestellten Aktor mit der vom Ventilmodul 5 bereitgestellten Druckluft versorgen zu können. An den Signalverarbeitungsmodulen 6 sind jeweils Signalstecker 16 ausgebildet, die eine elektrische Verbindung nicht dargestellter Externkomponenten, beispielsweise von Sensoren, mit der Modulanordnung 1 ermöglichen.

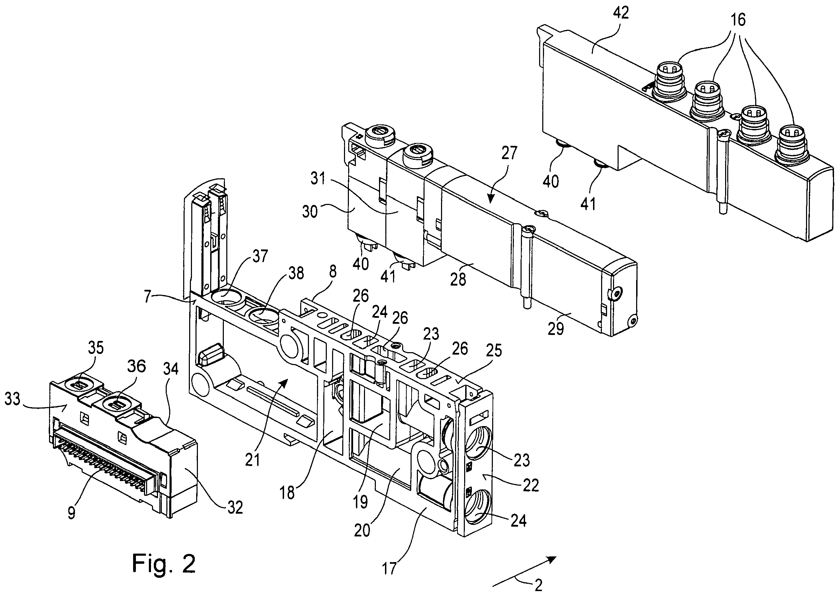

Aus der Explosionsdarstellung gemäß der Figur 2 gehen exemplarisch verschiedene Komponenten hervor, aus denen ein Funktionsmodul 3 aufgebaut werden kann. Eine zentrale Aufgabe kommt dem Grundkörper 17 zu, der von mehreren längs der Stapelrichtung 2 erstreckten Fluidkanälen 18, 19 und 20 sowie von einem Aufnahmeschacht 21 durchsetzt ist und der die Fügeflächen 7, 8 für die Anreihung an vorausgehende und nachfolgende Grundkörper 17 bereitstellt. Bei der Aneinanderreihung mehrerer Grundkörper 17 längs der Stapelrichtung 2 werden dadurch mehrere längs der Stapelrichtung 2 erstreckte Fluidkanäle gebildet, wodurch eine zentrale Versorgung und gegebenenfalls auch Abfuhr von Arbeitsfluid, beispielsweise Druckluft, für die gesamte Modulanordnung 1 erfolgen kann. An einer Stirnseite 22 des Grundkörpers 17 münden zwei Arbeitskanäle 23, 24 aus, die mit nicht dargestellten Steckverbindern zur werkzeuglosen Ankopplung von Druckluftschläuchen versehen werden können. Die Arbeitskanäle 23, 24 münden mit ihren der Stirnseite 22 abgewandten Endbereichen an einer Bestückungsfläche 25 des Grundkörpers 17 aus. An dieser Bestückungsfläche 25 münden auch jeweils mit einem der Fluidkanäle 18 bis 20 kommunizierend verbundene Querkanäle 26 aus.

Die an der Bestückungsfläche 25 ausmündenden Endbereiche der Arbeitskanäle 23, 24 können mit Hilfe von Ventilmitteln 28, 29, die auf die Bestückungsfläche aufsetzbar sind, zeitweilig in kommunizierende fluidische Verbindung miteinander gebracht werden, um beispielsweise eine Fluidströmung aus einem der Fluidkanäle 18 bis 20 in einen der Arbeitskanäle 23 oder 24 zu leiten oder umgekehrt. Hierzu sind die Ventilmittel 28, 29 mit nicht dargestellten Ventilgliedern und zugehörigen Ventilsitzen ausgestattet, wobei die Ventilglieder exemplarisch mit Hilfe von elektromechanischen Stellmitteln 30, 31, insbesondere Spulenantrieben, zwischen einer Öffnungsstellung und einer Schließstellung bewegbar sind.

Für eine Versorgung der Stellmittel 30, 31 mit elektrischer Energie ist im Aufnahmeschacht 21 des Grundkörpers 17 eine kassettenartig ausgebildete Leitungseinrichtung 32 anordenbar, die an einer ersten Seitenfläche 33 mit dem als Stecker 9 ausgebildeten Anschlussmittel versehen ist und an einer der Seitenfläche 33 entgegengesetzten Seitenfläche 34 eine zum Stecker 9 korrespondierende, in der Figur 2 nicht sichtbare Buchse aufweist. Die Leitungseinrichtung 32 ist geometrisch kodiert ausgebildet, so dass sie nur in einer einzigen Konfiguration in den Aufnahmeschacht 21 des Grundkörpers 17 eingeschoben werden kann. Nach dem Einschieben der Leitungseinrichtung 32 in den Aufnahmeschacht 21 des Grundkörpers 17 kommen zwei im Wesentlichen senkrecht zu den Seitenflächen 33, 34 ausgerichtete Steckbuchsen 35, 36 der Leitungseinrichtung 32 in Überdeckung mit Ausnehmungen 37, 38, die im Grundkörper 17 ausgebildet sind. Durch diese Ausnehmungen 37, 38 können entsprechend gestaltete Stecker 40, 41, die an den Stellmitteln 30, 31 ausgebildet sind, in die Steckbuchsen 35, 36 eingesteckt werden, um eine elektrische Verbindung zwischen den Stellmitteln 30, 31 und der Leitungseinrichtung 32 zu erzielen.

Gleichartig ausgebildete Stecker 40, 41 sind auch an der als Signalverarbeitungseinheit 42 ausgebildeten Funktionseinheit vorgesehen. Diese ermöglichen eine elektrische Kommunikation zwischen der Leitungseinrichtung 32 und der nicht dargestellten, in der Signalverarbeitungseinheit 42 aufgenommenen elektrischen Schaltung, die ihrerseits zur Kommunikation mit den nicht dargestellten Externkomponenten vorgesehen ist, die an den Signalsteckern 16 anschließbar sind.

Je nach Aufgabenstellung für ein Funktionsmodul 3 kann der Grundkörper 17 mit einer entsprechenden Funktionseinheit, beispielsweise der Ventileinheit 27 oder der Signalverarbeitungseinheit 42, und einer korrespondierend ausgebildeten Leitungseinrichtung 32 ausgestattet werden, so dass die Modulanordnung 1 nicht nur im Hinblick auf die aneinanderreihbaren Funktionsmodule 3, sondern auch im Hinblick auf die Gestaltung dieser Funktionsmodule 3 besonders flexibel gestaltbar ist.

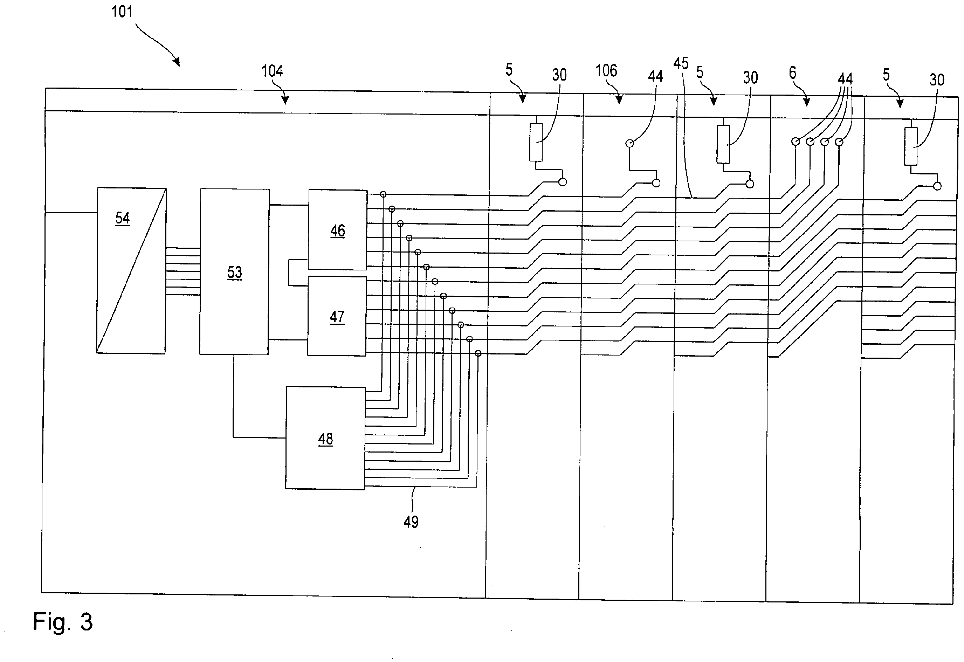

In den Figuren 3 bis 5 sind verschiedene Ausführungsformen von Modulanordnungen 101; 201; 301 dargestellt, bei denen jeweils funktionsgleiche Komponenten mit den gleichen Bezugszeichen versehen sind.

Bei der ersten Ausführungsform einer Modulanordnung 101 gemäß der Figur 3 können die Funktionsmodule 3 in beliebiger Reihenfolge an das Steuermodul 104 angereiht werden. Exemplarisch sind drei Ventilmodule 5 sowie ein Signalverarbeitungsmodul 6 und ein Signalverarbeitungsmodul 106 vorgesehen. Die Ventilmodule 5 umfassen aus Gründen der Übersichtlichkeit jeweils nur ein Stellmittel 30. Das Signalverarbeitungsmodul 106 ist derart ausgebildet, dass es zum Anschluss einer nicht dargestellten Externkomponente, beispielsweise eines Sensors, dienen kann. Die Externkomponente wird über einen nicht dargestellten Signalstecker mit dem Signalverarbeitungsmodul 106 gekoppelt, hierbei wird das elektrische Signal der Externkomponente über eine Verbindungsleitung an einen Knotenpunkt 44 einer Signalleitung 45 bereitgestellt. Die Signalleitung 45 ist in der Art einer Z-Verkettung durch die jeweils vorausgehenden Funktionsmodule 3 hindurchgeschleift.

Im Steuermodul 104 verzweigt sich die Signalleitung 45 und steht zum einen mit einer der Sendeeinrichtungen 46, 47 sowie mit einer Empfangseinrichtung 48 in elektrischer Verbindung. Die Sendeeinrichtungen 46 und 47 sind exemplarisch als Spulentreiber ausgebildet, die über die Signalleitungen 45 elektrische Energie an die damit verbundenen Stellmittel 30 zur Verfügung stellen können. Die Empfangseinrichtung 48 ist über Zweigleitungen 49 mit jeder der Signalleitungen 45 verbunden und kann entgegen der Stapelrichtung 2 laufende elektrische Signale aus den entsprechenden Signalleitungen 45 abgreifen und weiterverarbeiten.

Bei der Empfangseinrichtung 48 handelt es sich beispielsweise um einen auch als Latch bezeichneten Zwischenspeicher, der bei Eintreffen eines Signals über die entsprechende Signalleitung 45 und die Zweigleitung 49 in einen vorgegebenen Zustand geschaltet werden kann und diesen Schaltzustand über wenigstens eine Kommunikationsleitung 50 an einen Verarbeitungsbaustein 53, beispielsweise einen Mikroprozessor oder Mikrocontroller, weiterleiten kann. Der Verarbeitungsbaustein 53 steht hierbei in kommunizierender Verbindung mit einem Protokollbaustein 54, bei dem es sich beispielsweise um einen Buscontroller handeln kann, der für eine Kommunikation mit einem nicht dargestellten Datenbus, also einer übergeordneten Kommunikationseinrichtung, ausgebildet sein kann.

Abweichend von dem Signalverarbeitungsmodul 106 ist das Signalverarbeitungsmodul 6 für den Anschluss mehrerer Externkomponenten ausgebildet und umfasst daher mehrere Knotenpunkte 44. Da im Signalverarbeitungsmodul 6 aus den Z-verketteten Signalleitungen 45 insgesamt vier Signalleitungen 45 ausgeschleift werden, muss dementsprechend für die verbleibenden Signalleitungen 45 ein Versatz um ein Vierfaches der geometrischen Teilung zwischen benachbarten Signalleitungen 45 vollzogen werden, um eine ungestörte Kommunikation zwischen dem Steuermodul 104 und in Stapelrichtung 2 hinter dem Signalverarbeitungsmodul 6 angeordneten Funktionsmodulen 3 zu gewährleisten. Die Signale an den Knotenpunkten 44 werden in gleicher Weise wie beim Signalverarbeitungsmodul 106 über die Signalleitungen 45 und die Zweigleitungen 49 an die Empfangseinrichtung 48 weitergeleitet, um von dort nach Verarbeitung über die Kommunikationsleitung 50 an den Verarbeitungsbaustein 53 bereitgestellt zu werden. Bei dieser Ausführungsform einer Modulanordnung 101 ist vorteilhaft, dass die Signalverarbeitungsmodule 6, 106 an beliebiger Stelle zwischen den anderen Funktionsmodulen 3 angeordnet werden können, da sämtliche Signalleitungen 45 aufgrund der Verzweigung im Steuermodul 6 von der Empfangseinrichtung 48 überwacht werden können und somit entsprechende Sensorsignale auf den Signalleitungen 45 empfangen werden können. Bei einer nicht dargestellten Weiterbildung der Erfindung ist die Empfangseinrichtung auch als Sendeeinrichtung für Daten über die Signalleitungen an die Externkomponenten ausgebildet.

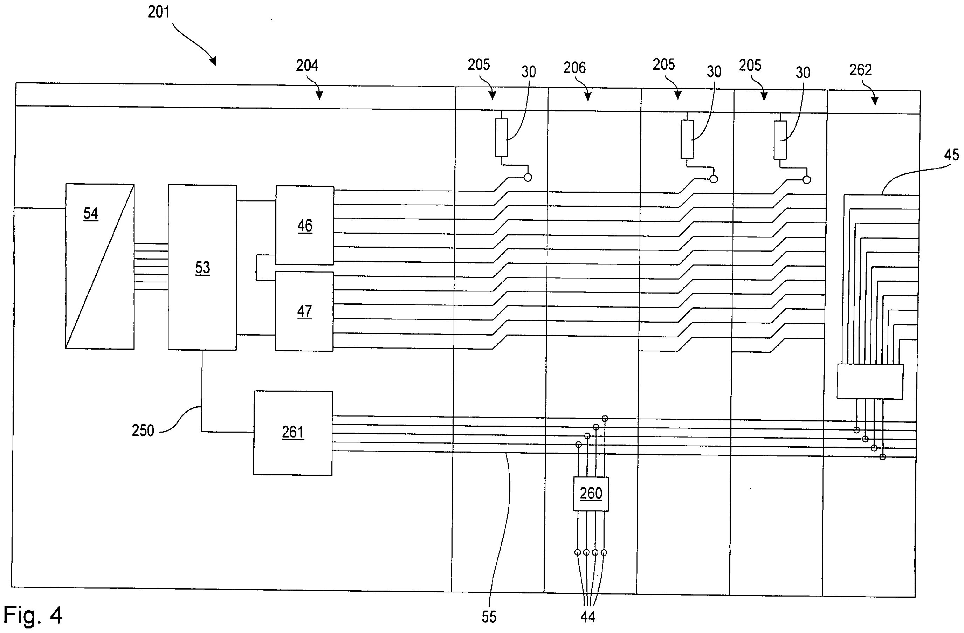

Bei der zweiten Ausführungsform einer Modulanordnung 201 gemäß der Figur 4 ist zusätzlich zu den Signalleitungen 45 ein exemplarisch mit fünf Datenleitungen 55 ausgebildetes serielles Bussystem vorgesehen, das parallel zur Stapelrichtung 2 verläuft und durch alle Funktionsmodule 3 hindurchgeschleift ist. In dem Signalverarbeitungsmodul 206 der Modulanordnung 201 ist ein Zwischenspeicher 260 angeordnet, der dazu ausgebildet ist, elektrische Signale nicht dargestellter Externkomponenten, die an den Knotenpunkten 44 angeschlossen sind, auf die Datenleitungen 55 des seriellen Bussystems einzukoppeln. Darüber hinaus kann der Zwischenspeicher 260 auch dazu ausgebildet sein, auf den Datenleitungen 55 gesendete elektrische Signale auszukoppeln, gegebenenfalls zu verarbeiten und an nicht dargestellte Externkomponenten weiterzuleiten. Für die Ansteuerung des seriellen Bussystems und der dazu vorgesehenen Datenleitungen 55 ist im Steuermodul 204 ein entsprechender interner Buscontroller 261 vorgesehen, der über wenigstens eine Kommunikationsleitung 250 mit dem Verarbeitungsbaustein 53 gekoppelt ist. Bei dieser Ausführungsform der Modulanordnung 201 ist vorteilhaft, dass die direkte Ansteuerung von Stellmitteln 30 über die Signalleitungen 45 erfolgen kann, während die Signale von Externkomponenten über die Datenleitungen 55 des Bussystems über den Buscontroller 261 an den Verarbeitungsbaustein 53 bereitgestellt werden. Dabei kann das serielle Bussystem in einer Doppelfunktion auch derart ausgebildet sein, dass es neben den elektrischen Signalen von Externkomponenten auch, insbesondere digitale, Steuersignale für Stellmittel 30, 31 überträgt, die in einem geeignet ausgebildeten Kopplungsmodul 262 auf entsprechende Signalleitungen 45 aufgeschaltet werden können, so dass die Modulanordnung 201 nicht durch die Anzahl der zur Verfügung gestellten Signalleitungen 45 limitiert wird.

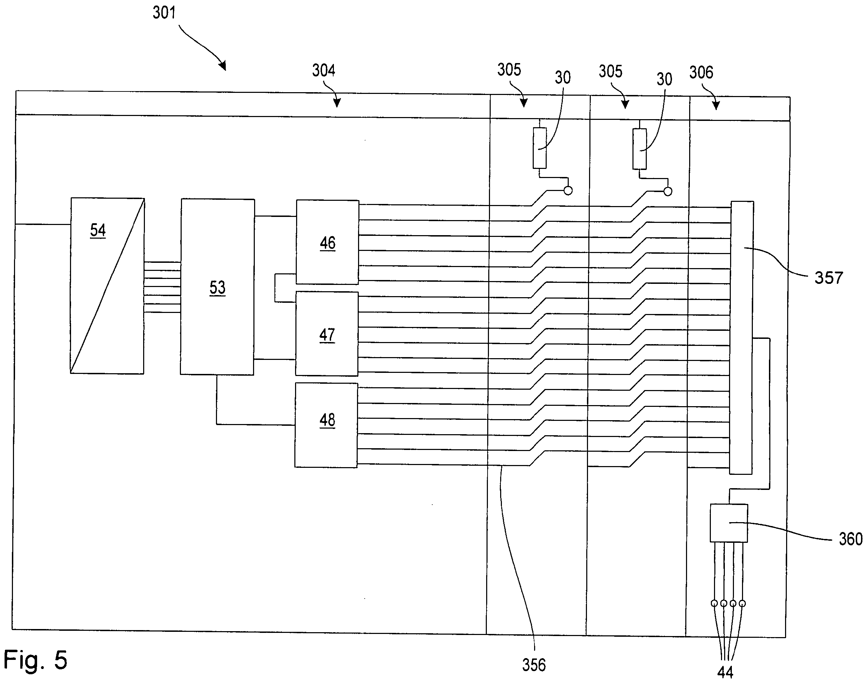

Bei der in Figur 5 dargestellten Ausführungsform einer Modulanordnung 301 sind zusätzlich zu den Signalleitungen 45 ebenfalls Z-verkettete Verbindungsleitungen 356 vorgesehen, die parallel zu den Signalleitungen 45 verlaufen. Sowohl die Signalleitungen 45 wie auch die Verbindungsleitungen 356 sind an einem Auswahlbaustein 357 angeschlossen. Der Auswahlbaustein 357 ist elektrisch mit einem Zwischenspeicher 360 gekoppelt, der seinerseits exemplarisch vier Anschlüsse für nicht dargestellte Externkomponenten aufweist. Die Aufgabe des Auswahlbausteins 357 besteht darin, unter den angeschlossenen Leitungen diejenigen zu identifizieren, die als Verbindungsleitungen 356 unmittelbar mit dem Verarbeitungsbaustein 53 verbunden sind, da über diese Verbindungsleitungen 356 eine direkte Datenkommunikation zwischen den Externkomponenten und dem Verarbeitungsbaustein 53 vorgenommen werden kann. Hierzu kann beispielsweise vorgesehen werden, bei Einschalten der Modulanordnung 301 zunächst mit Hilfe des Verarbeitungsbausteins 53 und den damit gekoppelten Sendeeinrichtungen 46, 47 Steuersignale über die Signalleitungen 45 auszugeben, die entweder an damit gekoppelte Stellmittel 30 bereitgestellt werden oder im Auswahlbaustein 357 detektiert werden können. Diejenigen Leitungen, über die entsprechende Steuersignale an den Auswahlbaustein 357 bereitgestellt werden, werden vom Auswahlbaustein 357 als Signalleitungen 45 qualifiziert und dienen somit nicht zur Datenübertragung zwischen Externkomponenten und dem Verarbeitungsbaustein 53. Hingegen können diejenigen Leitungen, über die keine Steuersignale an den Auswahlbaustein 357 zur Verfügung gestellt werden, als Verbindungsleitungen 356 kategorisiert werden, über die ein entsprechender Datenverkehr zwischen den Externkomponenten, der zwischengeschalteten Empfangseinrichtung 48 und dem Verarbeitungsbaustein 53 stattfinden kann. Da sich in Abhängigkeit von den zwischen das als letztes Funktionsmodul 3 in der Modulanordnung 301 angereihte Signalverarbeitungsmodul 306 und das Steuermodul 304 angereihte Funktionsmodule 3 im Hinblick auf die Belegung der Signalleitungen 45 unterschiedliche Leitungsbelegungen ergeben können, ist der Auswahlbaustein 357 dafür vorgesehen, die nicht für die Steuersignalübertragung eingesetzten Leitungen zu identifizieren, um hierüber die Datenkommunikation zwischen den Externkomponenten und dem Verarbeitungsbaustein 53 zu etablieren.

## Patentansprüche

1. Modulanordnung mit mehreren in einer Stapelrichtung (2) aneinandergereihten Funktionsmodulen (3), die untereinander fluidisch und elektrisch kommunizierend verbunden sind, wobei jeweils wenigstens ein Funktionsmodul (3) als Steuermodul (4; 104; 204; 304) zur Bereitstellung und/oder Verarbeitung von Signalen daran aufgereihter Funktionsmodule (3) und wenigstens ein Funktionsmodul (3) als Ventilmodul (5; 205; 305) zur Beeinflussung wenigstens einer Fluidströmung und wenigstens ein Funktionsmodul (3) als Signalverarbeitungsmodul (6; 106; 206; 306) zur Verarbeitung und/oder Ausgabe elektrischer Signale von und/oder an Externkomponenten ausgebildet ist und jeweils einen plattenförmigen Grundkörper (17) umfasst, der zwei zueinander parallele, einander entgegengesetzte Fügeflächen (7, 8) aufweist, deren Flächennormalen die Stapelrichtung (2) bestimmen und die zur Anlage an Fügeflächen (7, 8) benachbarter Grundkörper (17) ausgebildet sind, wobei der Grundkörper (17) Anschlussmittel (9, 10) aufweist, die für eine Weiterleitung von elektrischen Signalen und/oder elektrischen Versorgungsspannungen und/oder Fluidströmungen zwischen benachbarten Funktionsmodulen (3) längs der Stapelrichtung (2) ausgebildet sind und wobei sich mehrere vom Steuermodul (4; 104; 204; 304) ansteuerbare Signalleitungen (45) zur Übertragung von Steuersignalen, die zur direkten Ansteuerung einzelner Funktionsmodule (3) vorgesehen sind, längs der Stapelrichtung (2) der Funktionsmodule (3) erstrecken, **dadurch gekennzeichnet, dass** in wenigstens eine Signalleitung (45) zwischen das Signalverarbeitungsmodul (6; 106; 206; 306) und das Steuermodul (4; 104; 204; 304) wenigstens eine Speichereinrichtung (48; 260; 360) zur Erfassung, Zwischenspeicherung und Weiterleitung wenigstens eines elektrischen Signals einer Externkomponente elektrisch eingeschleift ist.

2. Modulanordnung nach Anspruch 1, **dadurch gekennzeichnet, dass** die Funktionsmodule (3) jeweils als Baugruppe aus dem Grundkörper (17) und einer daran angeordneten, als elektronische Steuereinheit und/oder fluidische Steuereinheit (27) und/oder Signalverarbeitungseinheit (42), modular ausgebildeten Funktionseinheit (3) aufgebaut sind.

3. Modulanordnung nach Anspruch 1 oder 2, **dadurch gekennzeichnet, dass** wenigstens eine Signalleitung (45) an einem ersten Endbereich mit einem Funktionsmodul (3) verbunden ist und an einem zweiten Endbereich eine, insbesondere im Steuermodul (4; 104; 204; 304) ausgebildete, elektrische Verzweigung aufweist, wobei ein erster Zweig der Signalleitung (45) mit einer im Steuermodul (4; 104; 204; 304) angeordneten Sendeeinrichtung (46, 47) und ein zweiter Zweig der Signalleitung (45) mit einer im Steuermodul (4; 104; 204; 304) angeordneten Empfangseinrichtung (48) elektrisch verbunden ist.

4. Modulanordnung nach Anspruch 3, **dadurch gekennzeichnet, dass** die Empfangseinrichtung (48) für eine Statusüberwachung eines vom Steuermodul (4; 104; 204; 304) an wenigstens ein Funktionsmodul (3) über die Signalleitung (45) übertragbaren Steuersignals ausgebildet ist.

5. Modulanordnung nach Anspruch 3 oder 4, **dadurch gekennzeichnet, dass** die Sendeeinrichtung (46, 47) und die Empfangseinrichtung (48) über eine im Steuermodul (4; 104; 204; 304) angeordnete Verarbeitungseinrichtung (53) miteinander gekoppelt sind, die derart ausgebildet ist, dass ein gleichzeitiges Senden von Steuersignalen über eine Signalleitung (45) und ein Empfangen von elektrischen Signalen einer Externkomponente auf der gleichen Signalleitung (45) verhindert wird.

6. Modulanordnung nach einem der Ansprüche 1 bis 5, **dadurch gekennzeichnet, dass** wenigstens eine Speichereinrichtung (48) zur Erfassung, Zwischenspeicherung und Weiterleitung wenigstens eines elektrischen Signals einer Externkomponente im Steuermodul (4; 104; 204; 304) ausgebildet ist.

7. Modulanordnung nach einem der Ansprüche 1 bis 6, **dadurch gekennzeichnet, dass** wenigstens eine Speichereinrichtung (260; 360) zur Erfassung, Zwischenspeicherung und Weiterleitung wenigstens eines elektrischen Signals einer Externkomponente in einem Funktionsmodul (3) ausgebildet ist.

8. Modulanordnung nach Anspruch 7, **dadurch gekennzeichnet, dass** der Speichereinrichtung (360) im Funktionsmodul (3) eine Auswahleinrichtung (357) zugeordnet ist, die zur Auswahl derjenigen Signalleitungen (45) ausgebildet ist, die mit einer im Steuermodul (304) angeordneten Empfangseinrichtung (48) elektrisch verbunden sind, um eine Signalübertragung von der Speichereinrichtung (360) über die ausgewählten Signalleitungen (356) zu gewährleisten.

9. Modulanordnung nach einem der vorhergehenden Ansprüche, **dadurch gekennzeichnet, dass** im Grundkörper (17) ein längs der Stapelrichtung (2) erstreckter Aufnahmeschacht (21) ausgebildet ist, in dem eine austauschbare, modular ausgebildete elektrische Leitungseinrichtung (32) angeordnet ist, durch die zumindest die Signalleitungen (45) längs der Stapelrichtung (2) durchgeschleift sind.

10. Modulanordnung nach Anspruch 9, **dadurch gekennzeichnet, dass** in der elektrischen Leitungseinrichtung (32) ein Versatz zumindest der der Signalleitungen (45) quer zur Stapelrichtung (2) um ein ganzzahliges Vielfaches einer Teilung benachbarter Signalleitungen (45) vorgesehen ist, um zumindest für die Signalleitungen (45) eine elektrische Z-Verkettung auszubilden.

11. Modulanordnung nach Anspruch 9 oder 10, **dadurch gekennzeichnet, dass** im Grundkörper (17) eine quer zur Stapelrichtung (2) ausgerichtete, vom Aufnahmeschacht (21) ausgehende Ausnehmung (37) ausgebildet ist, die eine elektrische Kopplung zwischen der Leitungseinrichtung (32) und der jeweils zugeordneten Funktionseinheit (27, 42) ermöglicht.

12. Modulanordnung nach einem der vorhergehenden Ansprüche, **dadurch gekennzeichnet, dass** ein serielles Bussystem zur Datenübertragung zwischen dem Steuermodul (204) und wenigstens einem Signalverarbeitungsmodul (206) vorgesehen ist und dass das Signalverarbeitungsmodul (206) mit Koppelmitteln (260) versehen ist, die zur Einkopplung von Signalen der Externkomponenten in das serielle Bussystem und/oder zur Auskopplung von Signalen an die Externkomponenten aus dem seriellen Bussystem ausgebildet sind.

13. Modulanordnung mit mehreren in einer Stapelrichtung (2) aneinandergereihten Funktionsmodulen (3), die untereinander fluidisch und elektrisch kommunizierend verbunden sind, wobei jeweils wenigstens ein Funktionsmodul (3) als Steuermodul (4; 104; 204; 304) zur Bereitstellung und/oder Verarbeitung von Signalen daran aufgereihter Funktionsmodule (3) und wenigstens ein Funktionsmodul (3) als Ventilmodul (5; 205; 305) zur Beeinflussung wenigstens einer Fluidströmung und wenigstens ein Funktionsmodul (3) als Signalverarbeitungsmodul (6; 106; 206; 306) zur Verarbeitung und/oder Ausgabe elektrischer Signale von und/oder an Externkomponenten ausgebildet ist und jeweils einen plattenförmigen Grundkörper (17) umfasst, der zwei zueinander parallele, einander entgegengesetzte Fügeflächen (7, 8) aufweist, deren Flächennormalen die Stapelrichtung (2) bestimmen und die zur Anlage an Fügeflächen (7, 8) benachbarter Grundkörper (17) ausgebildet sind, wobei der Grundkörper (17) Anschlussmittel (9, 10) aufweist, die für eine Weiterleitung von elektrischen Signalen und/oder elektrischen Versorgungsspannungen und/oder Fluidströmungen zwischen benachbarten Funktionsmodulen (3) längs der Stapelrichtung (2) ausgebildet sind, wobei ein serielles Bussystem zur Datenübertragung zwischen dem Steuermodul (204) und wenigstens einem Signalverarbeitungsmodul (206) vorgesehen ist und wobei das Signalverarbeitungsmodul (206) mit Koppelmitteln (260) versehen ist, die zur Einkopplung von Signalen der Externkomponenten in das serielle Bussystem und/oder zur Auskopplung von Signalen an die Externkomponenten aus dem seriellen Bussystem ausgebildet sind, **dadurch gekennzeichnet, dass** sich mehrere vom Steuermodul (4; 104; 204; 304) ansteuerbare Signalleitungen (45) zur Übertragung von Steuersignalen, die zur direkten Ansteuerung einzelner Funktionsmodule (3) vorgesehen sind, längs der Stapelrichtung (2) durch jedes der als Ventilmodul (5; 205; 305) oder als Signalverarbeitungsmodul (6; 106; 206; 306) ausgebildeten Funktionsmodule (3) erstrecken.

## Claims

1. Module assembly with a plurality of functional modules (3), which are lined up in a stacking direction (2) and are connected to one another for fluidic and electric communication, wherein in each case at least one functional module (3) is designed as a control module (4; 104; 204; 304) for providing and/or processing signals of functional modules (3) lined up thereon, and at least one functional module (3) is designed as a valve module (5; 205; 305) for influencing at least one fluid flow, and at least one functional module (3) is designed as a signal processing module (6; 106; 206; 306) for processing and/or outputting electric signals from and/or to external components and in each case comprises a plate-shaped base body (17) with two parallel and oppositely located joining surfaces (7, 8), the face normals of which determine the stacking direction (2) and which are designed for contact with joining surfaces (7, 8) of adjacent base bodies (17), wherein the base body (17) comprises connecting means (9, 10), which are designed for passing electric signals and/or electric supply voltages and/or fluid flows between adjacent functional modules (3) along the stacking direction (2), and wherein several signal lines (45) controllable by the control module (4; 104; 204; 304) for transmitting control signals provided for the direct control of individual functional modules (3) extend along the stacking direction (2) of the functional modules (3), **characterised in that** at least one storage device (48; 260; 360) for acquiring, buffering and transferring at least one electric signal of an external component is electrically looped into at least one signal line (45) between the signal processing module (6; 106; 206; 306) and the control module (4; 104; 204; 304).

2. Module assembly according to claim 1, **characterised in that** each of the functional modules (3) is constructed as an assembly from the base body (17) and a functional unit (3) of modular design located thereon and designed as an electronic control unit and/or a fluidic control unit (27) and/or a signal processing unit (42).

3. Module assembly according to claim 1 or 2, **characterised in that** at least one signal line (45) is connected to a functional module (3) in a first end region and has an electric branching formed in the control module (4; 104; 204; 304) in particular in a second end region, wherein a first branch of the signal line (45) is electrically connected to a transmitting device (46, 47) located in the control module (4; 104; 204; 304) and a second branch of the signal line (45) is electrically connected to a receiving device (48) located in the control module (4; 104; 204; 304).

4. Module assembly according to claim 3, **characterised in that** the receiving device (48) is designed for a status monitoring of a control signal which can be transmitted from the control module (4; 104; 204; 304) to at least one functional module (3) via the signal line (45).

5. Module assembly according to claim 3 or 4, **characterised in that** the transmitting device (46, 47) and the receiving device (48) are coupled to each other via a processing device (53) located in the control module (4; 104; 204; 304), which processing device (53) is designed such that a simultaneous transmission of control signals via a the signal line (45) and a reception of electric signals of an external component on the same signal line (45) is prevented.

6. Module assembly according to any of claims 1 to 5, **characterised in that** at least one storage device (48) is designed for acquiring, buffering and transferring at least one electric signal of an external component in the control module (4; 104; 204; 304).

7. Module assembly according to any of claims 1 to 6, **characterised in that** at least one storage device (260; 360) is designed for acquiring, buffering and transferring at least one electric signal of an external component in a functional module (3).

8. Module assembly according to claim 7, **characterised in that** the storage device (360) in the functional module (3) is assigned a selection device (357) designed for selecting those signal lines (45) which are electrically connected to a receiving device (48) located in the control module (304) in order to ensure a signal transmission from the storage device (360) via the selected signal lines (356).

9. Module assembly according to any of the preceding claims, **characterised in that** a reception shaft (21) extending along the stacking direction (2) is formed in the base body (17), in which reception shaft (21) there is arranged an exchangeable modular electric conducting device (32), through which at least the signal lines (45) are looped along the stacking direction (2).

10. Module assembly according to claim 9, **characterised in that** in the electric conducting device (32) there is provided an offset of at least the signal lines (45) at right angles to the stacking direction (2) by an integral multiple of a pitch of adjacent signal lines (45) in order to form an electric Z linkage for at least the signal lines (45).

11. Module assembly according to claim 9 or 10, **characterised in that** in the base body (17) there is formed a recess (37), which is oriented at right angles to the stacking direction (2) and starts from the reception shaft (21), and which facilitates an electric coupling between the conducting device (32) and the respectively assigned functional unit (27, 42).

12. Module assembly according to any of the preceding claims, **characterised in that** a serial bus system is provided for data transmission between the control module (204) and at least one signal processing module (206), and **in that** the signal processing module (206) is provided with coupling means (260) for coupling signals of the external components into the serial bus system and/or for coupling signals to the external components out of the serial bus system.

13. Module assembly with a plurality of functional modules (3), which are lined up in a stacking direction (2) and are connected to one another for fluidic and electric communication, wherein in each case at least one functional module (3) is designed as a control module (4; 104; 204; 304) for providing and/or processing signals of functional modules (3) lined up thereon, and at least one functional module (3) is designed as a valve module (5; 205; 305) for influencing at least one fluid flow, and at least one functional module (3) is designed as a signal processing module (6; 106; 206; 306) for processing and/or outputting electric signals from and/or to external components and in each case comprises a plate-shaped base body (17) with two parallel and oppositely located joining surfaces (7, 8), the face normals of which determine the stacking direction (2) and which are designed for contact with joining surfaces (7, 8) of adjacent base bodies (17), wherein the base body (17) comprises connecting means (9, 10), which are designed for passing electric signals and/or electric supply voltages and/or fluid flows between adjacent functional modules (3) along the stacking direction (2), wherein a serial bus system is provided for data transmission between the control module (204) and at least one signal processing module (206), and wherein the signal processing module (206) is provided with coupling means (260) for coupling signals of the external components into the serial bus system and/or for coupling signals to the external components out of the serial bus system, **characterised in that** several signal lines (45) controllable by the control module (4; 104; 204; 304) for transmitting control signals provided for the direct control of individual functional modules (3) extend along the stacking direction (2) of each of the functional modules (3) designed as a valve module (5; 205; 305) or as a signal processing module (6; 106; 206; 306).

## Revendications

1. Agencement de modules avec plusieurs modules fonctionnels (3) alignés dans un sens d'empilement (2), qui sont reliés entre eux par communication fluidique et électrique, dans lequel respectivement au moins un module fonctionnel (3) est réalisé en tant que module de commande (4 ; 104 ; 204 ; 304) pour la fourniture et/ou le traitement de signaux de modules fonctionnels (3) qui s'alignent sur celui-ci et au moins un module fonctionnel (3) est réalisé en tant que module de soupape (5 ; 205 ; 305) pour l'influence d'au moins un écoulement de fluide et au moins un module fonctionnel (3) est réalisé en tant que module de traitement de signaux (6 ; 106 ; 206 ; 306) pour le traitement et/ou la sortie de signaux électriques et/ou à des composants externes et comprend respectivement un corps de base (17) en forme de plaque, lequel présente deux surfaces d'assemblage (7, 8) opposées l'une à l'autre, parallèles l'une à l'autre, dont les normales à la surface déterminent le sens d'empilement (2) et qui sont réalisées pour l'application contre des surfaces d'assemblage (7, 8) de corps de base (17) adjacents, dans lequel le corps de base (17) présente des moyens de raccordement (9, 10), qui sont réalisés pour une transmission de signaux électriques et/ou de tensions d'alimentation électriques et/ou d'écoulements de fluide entre des modules fonctionnels (3) adjacents le long du sens d'empilement (2) et dans lequel plusieurs lignes de signalisation (45) pouvant être actionnées par le module de commande (4 ; 104; 204 ; 304) pour la transmission de signaux de commande, qui sont prévues pour l'actionnement direct de différents modules fonctionnels (3), s'étendent le long du sens d'empilement (2) des modules fonctionnels (3), **caractérisé en ce qu'**au moins un dispositif d'enregistrement (48 ; 260 ; 360) pour la détection, l'enregistrement intermédiaire et la transmission d'au moins un signal électrique d'un composant externe est intégré électriquement dans au moins une ligne de signalisation (45) entre le module de traitement de signaux (6 ; 106 ; 206 ; 306) et le module de commande (4 ; 104 ; 204 ; 304).

2. Agencement de modules selon la revendication 1, **caractérisé en ce que** les modules fonctionnels (3) sont construits respectivement en tant que sous-ensemble composé du corps de base (17) et d'une unité fonctionnelle (3) qui y est agencée, réalisée de manière modulaire en tant qu'unité de commande électronique et/ou d'unité de commande fluidique (27) et/ou d'unité de traitement de signaux (42).

3. Agencement de modules selon la revendication 1 ou 2, **caractérisé en ce qu'**au moins une ligne de signalisation (45) est reliée à un module fonctionnel (3) au niveau d'une première zone d'extrémité et présente au niveau d'une deuxième zone d'extrémité, une ramification électrique réalisée en particulier dans le module de commande (4 ; 104 ; 204 ; 304), dans lequel une première branche de la ligne de signalisation (45) est reliée électriquement à un dispositif d'émission (46, 47) agencé dans le module de commande (4 ; 104 ; 204 ; 304) et une deuxième branche de la ligne de signalisation (45) est reliée électriquement à un dispositif de réception (48) agencé dans le module de commande (4 ; 104 ; 204 ; 304).

4. Agencement de modules selon la revendication 3, **caractérisé en ce que** le dispositif de réception (48) est réalisé pour une surveillance d'état d'un signal de commande transmissible du module de commande (4 ; 104 ; 204 ; 304) à au moins un module fonctionnel (3) par le biais de la ligne de signalisation (45).

5. Agencement de modules selon la revendication 3 ou 4, **caractérisé en ce que** le dispositif d'émission (46, 47) et le dispositif de réception (48) sont couplés l'un à l'autre par le biais d'un dispositif de traitement (53), agencé dans le module de commande (4 ; 104 ; 204 ; 304), qui est réalisé de telle manière qu'une émission simultanée de signaux de commande par le biais d'une ligne de signalisation (45) et une réception de signaux électriques d'un composant externe sur la même ligne de signalisation (45) est empêchée.

6. Agencement de modules selon l'une quelconque des revendications 1 à 5, **caractérisé en ce qu'**au moins un dispositif d'enregistrement (48) pour la détection, l'enregistrement intermédiaire et la transmission d'au moins un signal électrique d'un composant externe est réalisé dans le module de commande (4 ; 104 ; 204 ; 304).

7. Agencement de modules selon l'une quelconque des revendications 1 à 6, **caractérisé en ce qu'**au moins un dispositif d'enregistrement (260 ; 360) pour la détection, l'enregistrement intermédiaire et la transmission d'au moins un signal électrique d'un composant externe est réalisé dans un module fonctionnel (3).

8. Agencement de modules selon la revendication 7, **caractérisé en ce qu'**un dispositif de sélection (357), qui est réalisé pour la sélection des lignes de signalisation (45) qui sont reliées électriquement à un dispositif de réception (48) agencé dans le module de commande (304) pour garantir une transmission de signal du dispositif d'enregistrement (360) par le biais des lignes de signalisation (356) sélectionnées, est affecté au dispositif d'enregistrement (360) dans le module fonctionnel (3).

9. Agencement de modules selon l'une quelconque des revendications précédentes, **caractérisé en ce qu'**un puits de logement (21) étendu le long du sens d'empilement (2), dans lequel un dispositif de ligne électrique (32) échangeable réalisé de manière modulaire est agencé, par lequel au moins les lignes de signalisation (45) sont bouclées le long du sens d'empilement (2), est réalisé dans le corps de base (17).

10. Agencement de modules selon la revendication 9, **caractérisé en ce qu'**un décalage au moins des lignes de signalisation (45) adjacentes aux lignes de signalisation (45) transversalement au sens d'empilement (2) d'un multiple entier d'une division est prévu dans le dispositif de ligne électrique (32), pour réaliser un raccordement en Z électrique au moins pour les lignes de signalisation (45).

11. Agencement de modules selon la revendication 9 ou 10, **caractérisé en ce qu'**un évidement (37) partant du puits de logement (21), orienté transversalement au sens d'empilement (2) et qui permet un couplage électrique entre le dispositif de ligne (32) et l'unité fonctionnelle (27, 45) respectivement affectée est réalisé dans le corps de base (17).

12. Agencement de modules selon l'une quelconque des revendications précédentes, **caractérisé en ce qu'**un système de bus série est prévu pour la transmission de données entre le module de commande (204) et au moins un module de traitement de signaux (206) et que le module de traitement de signaux (206) est doté de moyens de couplage (260), qui sont réalisés pour l'injection de signaux des composants externes dans le système de bus série et/ou pour l'extraction de signaux aux composants externes du système de bus série.

13. Agencement de modules avec plusieurs modules fonctionnels (3) alignés dans un sens d'empilement (2), qui sont reliés entre eux par communication fluidique et électrique, dans lequel respectivement au moins un module fonctionnel (3) est réalisé en tant que module de commande (4 ; 104 ; 204 ; 304) pour la fourniture et/ou le traitement de signaux de modules fonctionnels (3) qui s'alignent sur celui-ci et au moins un module fonctionnel (3) est réalisé en tant que module de soupape (5 ; 205 ; 305) pour l'influence d'au moins un écoulement de fluide et au moins un module fonctionnel (3) est réalisé en tant que module de traitement de signaux (6 ; 106 ; 206 ; 306) pour le traitement et/ou la sortie de signaux électriques de et/ou à des composants externes et comprend respectivement un corps de base (17) en forme de plaque, lequel présente deux surfaces d'assemblage (7, 8) opposées l'une à l'autre, parallèles l'une à l'autre, dont les normales à la surface déterminent le sens d'empilement (2) et qui sont réalisées pour l'application contre des surfaces d'assemblage (7, 8) de corps de base (17) adjacents, dans lequel le corps de base (17) présente des moyens de raccordement (9, 10), qui sont réalisés pour une transmission de signaux électriques et/ou de tensions d'alimentation électriques et/ou d'écoulements de fluide entre des modules fonctionnels (3) adjacents le long du sens d'empilement (2), dans lequel un système de bus série est prévu pour la transmission de données entre le module de commande (204) et au moins un module de traitement de signaux (206) et dans lequel le module de traitement de signaux (206) est doté de moyens de couplage (260) qui sont réalisés pour l'injection de signaux des composants externes dans le système de bus série et/ou pour l'extraction de signaux aux composants externes du système de bus série, **caractérisé en ce que** plusieurs lignes de signalisation (45) actionnables par le module de commande (4 ; 104 ; 204 ; 304) pour la transmission de signaux de commande, qui sont prévues pour l'actionnement direct de différents modules fonctionnels (3), s'étendent le long du sens d'empilement (2) par chacun des modules fonctionnels (3) réalisés en tant que module de soupape (5 ; 205 ; 305) ou en tant que module de traitement de signaux (6 ; 106 ; 206 ; 306).
